# EUROPEAN PATENT APPLICATION

(11) **EP 4 270 499 A1**
(43) Date of publication of application: **01.11.2023**
(21) Application number: 21910983.2
(22) Date of filing: 23.12.2021
(51) Int. Cl.: H01L 33/58, C03C 27/04, C23C 14/14, G02B 1/00

(54) **SILICA MEMBER AND LED DEVICE**

(30) Priority: 25.12.2020 JP 2020217879; 22.10.2021 JP 2021172818; 20.12.2021 JP 2021206469
(71) Applicant: Coorstek KK, Tokyo 141-0032 (JP)
(72) Inventor: MIYAMOTO, Shintaro, Hadano-shi, Kanagawa 257-8566 (JP); VALLEPU, Ramesh, Hadano-shi, Kanagawa 257-8566 (JP); KOBAYASHI, Hiroaki, Hadano-shi, Kanagawa 257-8566 (JP); YOKOYAMA, Yu, Hadano-shi, Kanagawa 257-8566 (JP)
(74) Representative: Grünecker Patent- und Rechtsanwälte PartG mbB
(86) International application number: PCT/JP2021/047953
(87) International publication number: WO 2022/138844

(57) **Abstract**

The present invention relates to a silica member including a main body including silica glass, in which the main body has an other member-joining portion for joining to another member, in which the other member-joining portion has a base layer, an intermediate layer, and a surface layer comprising Au that are formed on the other member-joining portion in this order from the main body, and in which the base layer has a porosity of higher than or equal to 5% and lower than or equal to 10%, the intermediate layer has a porosity of higher than or equal to 4% and lower than or equal to 5%, the base layer has a thickness of larger than or equal to 20 nm and smaller than or equal to 100 nm, and the intermediate layer has a thickness of larger than or equal to 100 nm and smaller than or equal to 200 nm.

## Description

### TECHNICAL FIELD

The present invention relates to a silica member and an LED device and, more particularly, to a silica member that is suitably used as a cap, a lens, etc. for an ultraviolet LED (light-emitting diode) and an LED device using it.

### BACKGROUND ART

Conventionally, mercury lamps have been used widely for ultraviolet sterilization. In that situation, because of coming into effect of "The Minamata Convention on Mercury," manufacture, export, and import of mercury products have been restricted from the year 2020. As a result, ultraviolet LEDs, in particular, deep ultraviolet LEDs that are 280 nm or shorter in wavelength, are attracting attention as replacement light sources to be used after the end of life of currently used mercury lamps. For example, LEDs are used in such a manner as to be installed in a body and sealed by a glass lens or the like.

For example, Patent document 1 discloses a light-emitting module in which a package substrate made of ceramic such as aluminum nitride and a window member made of quartz glass are joined to each other by a sealing portion made of a low-melting-temperature metal material such as AuSn (gold tin) or AgSn (silver tin). A multilayer film is formed on a joining portion, for joining to the package substrate, of the window member in such a manner that Ti (titanium), Cu (copper), Ni (nickel), and Au (gold) are laid on each other in this order from the side of the joining portion and a joining portion, for joining to the window member, of the package substrate is metallized.

For another example, Patent document 2 discloses an LED device in which a main body having a lens portion and a flange portion and made of silica glass and a body made of aluminum nitride are welded to each other with AuSn solder. A 0.5-µm-thick Cu layer is formed as a base layer by wet plating on the flange portion for joining to the body. A 0.5-µm-thick Au layer is formed on the surface of the Cu layer by wet plating. A body metallized layer in which an Ni layer and an Au layer are formed in this order is formed in a portion, for joining to the main body, of the body.

### CITATION LIST

### PATENT LITERATURE

[Patent document 1] JP-A-2017-59716
[Patent document 2] JP-A-2019-46826

### SUMMARY OF INVENTION

### TECHNICAL PROBLEM

However, in the conventional techniques, metal layers of Ti, Cu, Ni, Au, etc. are formed densely on the surface of a member made of silica glass in a portion where the member made of silica glass and a member made of ceramic are joined to each other. This results in a problem that stress is produced by heat when the member made of silica glass and the member made of ceramic are joined because of differences between the thermal expansion coefficients of the silica glass and the metals. As a result, a load is imposed on the silica glass member to break it.

The present invention has been made in view of the above problems, and an object of the invention is therefore to provide a silica member that enables satisfactory joining while preventing its breaking as well as an LED device using the silica member.

### SOLUTION TO PROBLEM

A silica member according to the invention includes a main body including silica glass,
in which the main body has an other member-joining portion for joining to another member,
in which the other member-joining portion has a base layer, an intermediate layer, and a surface layer including Au that are formed on the other member-joining portion in this order from the main body, and
in which the base layer has a porosity of higher than or equal to 5% and lower than or equal to 10%, the intermediate layer has a porosity of higher than or equal to 4% and lower than or equal to 5%, the base layer has a thickness of larger than or equal to 20 nm and smaller than or equal to 100 nm, and the intermediate layer has a thickness of larger than or equal to 100 nm and smaller than or equal to 200 nm.

An LED device according to the invention includes:
an LED;
a base member which supports the LED; and
the silica member according to the invention that is joined to the base member so as to cover the LED,
in which the base member has a silica member-joining portion for joining to the silica member,
in which a metallized layer including a first layer including Au on its surface is formed on the silica member-joining portion, and
in which the other member-joining portion of the silica member is joined to the silica member-joining portion of the base member by a solder layer including an AuSn solder.

### ADVANTAGEOUS EFFECTS OF INVENTION

In the silica member according to the invention, the base layer, the intermediate layer, and the surface layer including Au are formed on the other member-joining portion of the main body including silica glass and the porosity of the base layer is set higher than or equal to 5% and lower than or equal to 10% and the porosity of the intermediate layer is set higher than or equal to 4% and lower than or equal to 5%. Thus, stress that occurs when the main body is joined to another member is lowered, breaking of the main body is prevented, and the main body is joined to another member strongly to secure necessary airtightness.

Furthermore, setting the thickness of the base layer larger than or equal to 20 nm and smaller than or equal to 100 nm makes it possible to lower the internal stress while securing necessary adhesion. Still further, setting the thickness of the intermediate layer larger than or equal to 100 nm and smaller than or equal to 200 nm makes it possible to lower the internal stress while allowing the intermediate layer to function as a barrier layer for preventing diffusion of Sn atoms of solder.

Setting the porosity of the base layer higher than that of the intermediate layer makes it possible to increase the adhesion between the base layer and the intermediate layer while lowering the load that is imposed by stress, thus making it possible to secure necessary airtightness while reducing the stress effectively.

Setting the porosity of the surface layer higher than or equal to 0.1% and lower than or equal to 0.5% and setting the thickness of the surface layer larger than or equal to 150 nm and smaller than or equal to 500 nm make it possible to bond the main body to the other member strongly by solder while suppressing increase of the internal stress.

In addition, where the base layer includes at least one of a Cr (chromium) layer and a Ti layer, its adhesion to the main body which is made of silica glass can be increased. Where the intermediate layer includes at least one of an Ni layer and a Ti layer, a phenomenon that Sn atoms contained in the solder enters the base layer can be suppressed, whereby lowering of the adhesion between the other member-joining portion and the base layer can be suppressed.

Moreover, where the average particle diameter of the base layer as measured by a linear intercept method is preferably larger than or equal to 40 nm and smaller than or equal to 80 nm, the average particle diameter of the intermediate layer as measured by the linear intercept method is preferably larger than or equal to 50 nm and smaller than or equal to 70 nm, and the average particle diameter of the surface layer as measured by the linear intercept method is preferably larger than or equal to 50 nm and smaller than or equal to 70 nm, voids are formed in a proper manner and hence their Young's moduli can be decreased to prescribed ranges. As a result, each layer is allowed to deform easily and the internal stress produced at the time of film formation can be lowered.

In the LED device according to the invention, the silica member according to the invention is used, the metallized layer having the first layer including Au on its surface is formed on the silica member-joining portion of the base member, and the other memberjoining portion of the silica member is joined to the silica member-joining portion of the base member by the solder layer including AuSn solder. Thus, other member-joining portion can be joined to the silica member-joining portion satisfactorily.

### BRIEF DESCRIPTION OF DRAWINGS

FIG. 1A and FIG. 1B show the configuration of an LED lens which is a silica member according to a first embodiment of the present invention.
FIG. 2A and FIG. 2B show sectional views showing the configuration of an LED device which uses the LED lens shown in FIG. 1A and FIG. 1B.
FIG. 3A and FIG. 3B show the configuration of an LED cap which is a silica member according to a second embodiment of the invention.
FIG. 4A to FIG. 4C show images of particle states of a base layer in Inventive Example 1.
FIG. 5A to FIG. 5C show images of particle states of an intermediate layer in Inventive Example 1.
FIG. 6A to FIG. 6C show images of particle states of a surface layer in Inventive Example 1.

### DESCRIPTION OF EMBODIMENTS

Embodiments of the present invention will be hereinafter described in detail with reference to the drawings.

### (First embodiment)

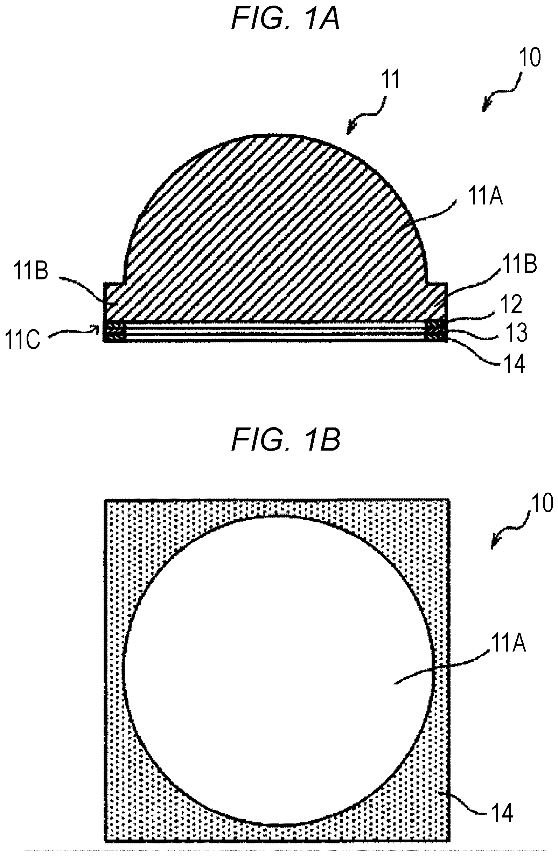

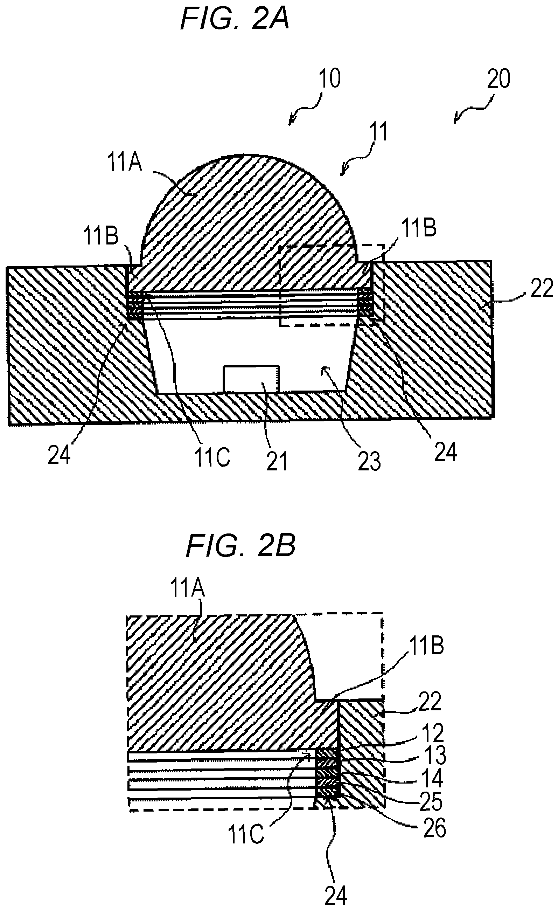

FIG. 1A and FIG. 1B show the configuration of an LED lens 10 which is a silica member according to a first embodiment; FIG. 1A shows a sectional configuration; and FIG. 1B shows a configuration viewed from bottom. FIG. 2A and FIG. 2B are sectional views of an LED device 20 using the LED lens 10; FIG. 2A shows an overall configuration; and FIG. 2B is an enlarged view of a part indicated by the broken line in FIG. 2A.

The LED lens 10 includes a main body 11 made of silica glass. For example, the main body 11 has a semispherical lens portion 11A and a flange portion 11B which is an outer circumferential portion of a flat-plane-side portion of the lens portion 11A. For example, the LED lens 10 is used for the LED device 20.

For example, the LED device 20 includes the LED lens 10, an LED 21, and a base member 22 which supports the LED 21 and the LED lens 10 is mounted on the base member 22 so as to cover the LED 21. For example, the base member 22 is formed with a recess 23 in which the LED 21 is provided and a step portion 24 on which the LED lens 10 is mounted is formed above the recess 23. For example, the LED lens 10 is disposed in such a manner that its flange portion 11B is in contact with the step portion 24 and the bottom surface of the flange portion 11B is joined to the top surface of the step portion 24. That is, the bottom surface of the flange portion 11B of the LED lens 10 is an other member-joining portion 11C for joining to the base member 22 which is another member, and the top surface of the step portion 24 of the base member 22 is a silica member-joining portion for joining to the LED lens 10 which is the silica member.

The bottom surface of the flange portion 11B of the LED lens 10 and the top surface of the step portion 24 of the base member 22 are joined to each other by, for example, welding with a solder layer 25. This is to attain sealing with high airtightness. It is preferable that a material of the solder layer 25 is AuSn solder. It is preferable that a metallized layer 26 is formed on the top surface of the step portion 24 to increase the wettability with solder. It is preferable that, for example, the metallized layer 26 have a first layer made of Au as a surface layer and have an Ni layer between the first layer and the step portion 24.

Abase layer 12, an intermediate layer 13, and a surface layer 14 made of Au are formed in order from the main body 11 side on the bottom surface of the flange portion 11B of the LED lens 10, that is, the other member-joining portion 11C. This is to increase the compatibility with solder by metalizing the surface of the silica glass because it does not tend to be wet with solder. In particular, since Au is alloyed by reacting with AuSn solder to form an intermetallic compound such as AusSn, AuSn, AuSn₂, or AuSn₄, the compatibility with solder can be increased by forming the surface layer 14 with Au. The region where the base layer 12, the intermediate layer 13, and the surface layer 14 are formed is dotted in FIG. 1B.

The base layer 12 serves to increase the adhesion with the silica glass to prevent occurrence of peeling there. The base layer 12 is made of, for example, a metal and may be either a single layer or plural laminated layers. It is preferable that the base layer 12 include at least one of a Cr layer and a Ti layer, and be, for example, a Cr layer, a Ti layer, or plural layers formed by laminating a Cr layer and a Ti layer. This is because, Cr and Ti enable high adhesion with silica glass.

The intermediate layer 13 serves to suppress entrance of Sn atoms contained in the solder layer 25 into the base layer 12 and thereby prevent reduction of the adhesion between the other member-joining portion 11C and the base layer 12. The intermediate layer 13 is made of, for example, a metal and may be either a single layer or plural laminated layers. It is preferable that the intermediate layer 13 include at least one of an Ni layer and a Ti layer, and be, for example, an Ni layer, a Ti layer, or plural layers formed by laminating an Ni layer and a Ti layer. This is because Ni and Ti are high in the effect of suppressing entrance of Sn atoms into the base layer 12.

It is preferable that the porosity of the base layer 12 is higher than or equal to 5% and lower than or equal to 10% and the porosity of the intermediate layer 13 is higher than or equal to 4% and lower than or equal to 5%. This is to decrease internal stress that occurs when the main body 11 is joined to the base member 22 due to the difference between the thermal expansion coefficients of the silica glass and the metal, by controlling the porosities (film densities). If the porosity of the base layer 12 is lower than 5%, the stress cannot be lowered sufficiently and hence the surface of the main body 11 is prone to break. On the other hand, if the porosity of the base layer 12 is higher than 10%, the adhesion between the main body 11 and the base member 22 is insufficient and hence peeling is prone to occur at the time of joining. Thus, necessary airtightness cannot be secured and it is difficult to obtain satisfactory bonding.

If the porosity of the intermediate layer 13 is lower than 4%, the stress cannot be lowered sufficiently, which adversely affects breaking of the main body 11. If the porosity of the intermediate layer 13 is higher than 5%, the adhesion between the base layer 12 and the intermediate layer 13 is insufficient, as a result of which peeling may occur at the interface between the base layer 12 and the intermediate layer 13 when the main body 11 is joined to the base member 22. Furthermore, Sn atoms of the solder are prone to diffuse into the intermediate layer 13 and the base layer 12 at the time of soldering, as a result of which deterioration of the joining interface between the other memberjoining portion 11C and the base layer 12 is accelerated to shorten the life of the LED device 20.

It is preferable that the thickness of the base layer 12 is larger than or equal to 20 nm and smaller than or equal to 100 nm. If the thickness of the base layer 12 is smaller than 20 nm, adhesion to the other member-joining portion 11C is insufficient due to high porosity and hence peeling at the time of joining with the base member 22 is prone to occur. If the thickness of the base layer 12 is larger than 100 nm, the internal stress becomes so large that the main body 11 is made prone to break. It is preferable that the thickness of the intermediate layer 13 is larger than or equal to 100 nm and smaller than or equal to 200 nm. If the thickness of the intermediate layer 13 is smaller than 100 nm, its function as a barrier layer for preventing diffusion of Sn atoms of the solder is degraded. If the thickness of the intermediate layer 13 is larger than 200 nm, the internal stress becomes so large that the main body 11 is made prone to break. Furthermore, if the thickness of the intermediate layer 13 is larger than 200 nm, the intermediate layer 13 shrinks and hence cracks are prone to develop at the time of cooling after formation of the films.

It is preferable that the base layer 12 is higher in porosity than the intermediate layer 13. Increasing the porosity of the base layer 12 produces an effect of lowering the load of stress on the main body 11. Setting the porosity of the intermediate layer 13 lower than that of the base layer 12 makes it possible to increase the adhesion between the base layer 12 and the intermediate layer 13 while lowering the load of stress on the main body 11, whereby necessary airtightness can be secured while the stress can be lowered effectively.

It is preferable that the porosity of the surface layer 14 is higher than or equal to 0.1% and lower than or equal to 0.5%. This is because the surface layer 14 can be bonded more strongly to the metallized layer 26 formed on the step portion 24 by the solder layer 25. The porosities of the base layer 12, the intermediate layer 13, and the surface layer 14 can be controlled by, for example, adjusting the pressure or the input power when they are formed by vacuum evaporation, sputtering, or the like.

It is preferable that the thickness of the surface layer 14 is larger than or equal to 150 nm and smaller than or equal to 500 nm. If the thickness of the surface layer 14 is larger than or equal to 150 nm, deterioration of joining strength of the surface layer 14 due to alloying of the entire surface layer 14 caused by diffusion of Sn atoms of the solder into the surface layer 14 during soldering can be prevented. As a result, the strength of joining between the main body 11 and the base member 22 is increased, as a result of which peeling is prevented to prolong the life of the LED device 20. If the thickness of the surface layer 14 is smaller than or equal to 500 nm, the internal stress becomes small and breaking can be prevented form occurring. As a result, progression of diffusion of Sn atoms originated from the breaking portion, and difficulty in joining caused by that the solder becomes less meltable due to melting point increase by concentration reduction of the solder can be prevented. A thickness of each layer can be measured by observing the composition of a cross section of each layer using an FE-SEM (field emission scanning electron microscope).

The term "porosity" as used in the invention means a two-dimensional porosity obtained by dividing a total area of void portions by an entire area in an image obtained by shooting the top surface of the base layer 12, the intermediate layer 13, or the surface layer 14. More specifically, for example, a porosity can be calculated by shooting the top surface of the base layer 12, the intermediate layer 13, or the surface layer 14 by the FE-SEM (S-4800) produced by Hitachi High-Technologies Corporation and binarizing void portions of the obtained image by an image processing module OpenCV using a programming language Python. In doing so, portions where the contrast varies to a large extent in the image are judged pores. Shooting of the top surface of the base layer 12 or the intermediate layer 13 is performed in such a manner that the surface of the base layer 12 or the intermediate layer 13 is exposed by, for example, removing the surface layer 14 and the intermediate layer 13 or the surface layer 14 by etching or the like.

It is preferable that the average particle diameter of the base layer 12 as measured by a linear intercept method is larger than or equal to 40 nm and smaller than or equal to 80 nm, that the average particle diameter of the intermediate layer 13 as measured by the linear intercept method is larger than or equal to 50 nm and smaller than or equal to 70 nm, and that the average particle diameter of the surface layer 14 as measured by the linear intercept method is larger than or equal to 50 nm and smaller than or equal to 70 nm. By setting the average particle diameters in the above ranges, voids are formed in each layer in a proper manner and the Young's modulus can be reduced to a prescribed range, whereby each layer is allowed to deform easily and the internal stress produced at the time of film formation can be lowered.

It is preferable that the Young's modulus of the base layer 12 is larger than or equal to 30% and smaller than or equal to 70% of the Young's modulus of a bulk of a material constituting the base layer 12, that the Young's modulus of the intermediate layer 13 is larger than or equal to 40% and smaller than or equal to 80% of the Young's modulus of a bulk of a material constituting the intermediate layer 13, and that the Young's modulus of the surface layer 14 is larger than or equal to 20 GPa and smaller than or equal to 60 GPa.

In the invention, the term "average particle diameter as measured by a linear intercept method" means an average particle diameter observed in the top surface of the base layer 12, the intermediate layer 13, or the surface layer 14 that is measured by a linear intercept method in accordance with ISO 13383-1: 2012. More specifically, for example, the top surface of the base layer 12, the intermediate layer 13, or the surface layer 14 is shot by the FE-SEM (S-4800) produced by Hitachi High-Technologies Corporation, 10 straight lines are drawn in an image taken, the number of particles located on the straight lines is counted, and a particle diameter is calculated by dividing the sum of the lengths of the straight lines by the count. The top surface of the base layer 12 or the intermediate layer 13 is observed by exposing it by, for example, removing the surface layer 14 and the intermediate layer 13 or the surface layer 14 by etching or the like.

A Young's modulus of the base layer 12, the intermediate layer 13, or the surface layer 14 is measured by a surface acoustic wave method (according to the DIN (German Institute for Standardization) standard 50992-1) in which, for example, surface acoustic waves produced by irradiating a sample with pulse laser light (wavelength: 337 nm) are measured by a piezoelectric element and a Young's modulus is calculated from a dispersion curve. A measurement is performed after the surface of the base layer 12 or the intermediate layer 13 is exposed by removing the surface layer 14 and the intermediate layer 13 or the surface layer 14 by etching or the like.

Where the base layer 12 or the intermediate layer 13 is made up of plural layers, the Young's modulus of the base layer 12 or the intermediate layer 13 is judged for each of the layers constituting the base layer 12 or the intermediate layer 13. That is, it is preferable that in the case of the base layer 12 the Young's modulus of each of the layers constituting the base layer 12 is larger than or equal to 30% and smaller than or equal to 70% of the Young's modulus of bulk of a material constituting that layer, and that in the case of the intermediate layer 13 the Young's modulus of each of the layers constituting the intermediate layer 13 is larger than or equal to 40% and smaller than or equal to 80% of the Young's modulus of bulk of a material constituting that layer.

For example, the LED lens 10 can be manufactured in the following manner. First, a main body 11 is formed using silica glass. For example, a main body 11 is formed by molding silica powder by a gel cast method and sintering it. Then a base layer 12, an intermediate layer 13, and a surface layer 14 are laid in this order on at least part of the bottom surface of the flange portion 11B, that is, the other member-joining portion 11C. For example, the base layer 12, the intermediate layer 13, and the surface layer 14 are formed by vacuum evaporation or sputtering in such a manner that the porosity of each layer is adjusted by adjusting the pressure properly in, for example, a range of 0.5 Pa to 3.0 Pa and adjusting the input power properly in, for example, a range of 50 W to 200 W.

The resulting LED lens 10 is joined to a base member 22 by a solder layer 25, for example. For example, tape-shaped solder is put on a step portion 24, formed with a metallized layer 26, of the base member 22. Then the LED lens 10 is put on the solder such that the other member-joining portion 11C, formed with the base layer 12, the intermediate layer 13, and the surface layer 14, of the flange portion 11B is brought into contact with the solder. The LED lens 10 is thereafter welded to the base member 22 with heat-melting the solder in an oxygen-free atmosphere.

As described above, in this embodiment, the base layer 12, the intermediate layer 13, and the surface layer 14 made of Au are formed on the other member-joining portion 11C of the main body 11 made of silica glass. The porosity of the base layer 12 is set higher than or equal to 5% and lower than or equal to 10% and the porosity of the intermediate layer 13 is set higher than or equal to 4% and lower than or equal to 5%. Thus, stress that occurs when the main body 11 is joined to the base member 22 is lowered, breaking of the main body 11 is prevented, and the main body 11 is joined to the base member 22 strongly to secure necessary airtightness.

Furthermore, setting the thickness of the base layer 12 larger than or equal to 20 nm and smaller than or equal to 100 nm makes it possible to lower the internal stress while securing necessary adhesion. Still further, setting the thickness of the intermediate layer 13 larger than or equal to 100 nm and smaller than or equal to 200 nm makes it possible to lower the internal stress while allowing the intermediate layer 13 to function as a barrier layer for preventing diffusion of Sn atoms of solder.

Setting the porosity of the base layer 12 higher than that of the intermediate layer 13 makes it possible to increase the adhesion between the base layer 12 and the intermediate layer 13 while lowering the load that is imposed by stress, thus making it possible to secure necessary airtightness while reducing the stress effectively.

Setting the porosity of the surface layer 14 higher than or equal to 0.1% and lower than or equal to 0.5% and setting the thickness of the surface layer 14 larger than or equal to 150 nm and smaller than or equal to 500 nm make it possible to bond the main body 11 and the base member 22 strongly by solder while suppressing increase of the internal stress.

In addition, where the base layer 12 includes at least one of a Cr layer and a Ti layer, its adhesion to the main body 11 which is made of silica glass can be increased. Where the intermediate layer 13 includes at least one of an Ni layer and a Ti layer, a phenomenon that Sn atoms contained in the solder enters the base layer 12 can be suppressed, whereby lowering of the adhesion between the other member-joining portion 11C and the base layer 12 can be suppressed.

Moreover, where the average particle diameter of the base layer 12 as measured by the linear intercept method is preferably larger than or equal to 40 nm and smaller than or equal to 80 nm, the average particle diameter of the intermediate layer 13 as measured by the linear intercept method is preferably larger than or equal to 50 nm and smaller than or equal to 70 nm, and the average particle diameter of the surface layer 14 as measured by the linear intercept method is preferably larger than or equal to 50 nm and smaller than or equal to 70 nm, voids are formed in a proper manner and hence their Young's moduli can be decreased to prescribed ranges. As a result, each layer is allowed to deform easily and the internal stress produced at the time of film formation can be lowered.

### (Second embodiment)

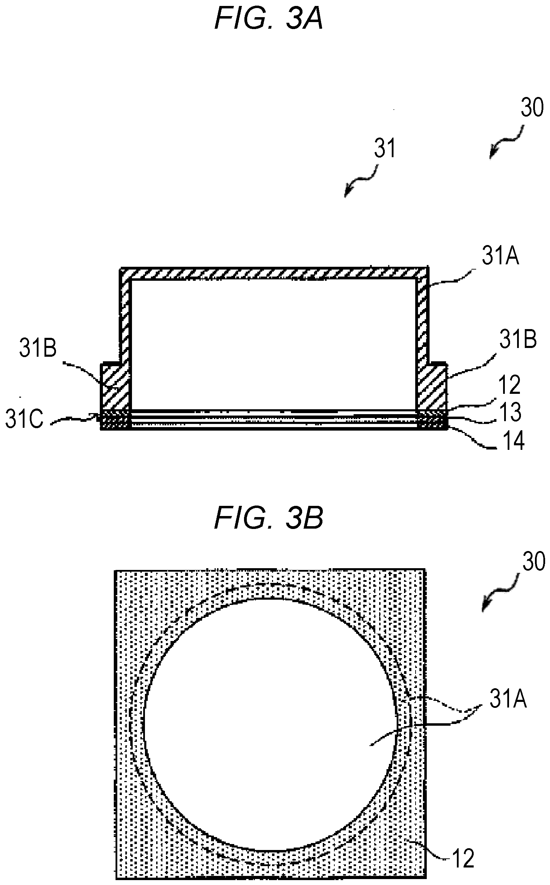

FIG. 3A and FIG. 3B show the configuration of an LED cap 30 which is a silica member according to a second embodiment; FIG. 3A shows a sectional configuration; and FIG. 3B shows a configuration viewed from bottom. The LED cap 30 has the same configuration as the LED lens 10 according to the first embodiment except the shape of a main body 31. Thus, constituent elements of the LED cap 30 which are same as the constituent elements of the LED lens 10 will be given the same reference symbols, and constituent elements of the LED cap 30 corresponding to the constituent elements of the LED lens 10 will be given reference symbols whose tens place is changed to "3". By using these reference symbols, these constituent elements of the LED cap 30 will not be described in detail.

The main body 31 is made of silica glass and has, for example, a cap portion 31A that is shaped like a one-end-sealed cylinder and a flange portion 31B provided at the open end portion of the cap portion 31A. As with the first embodiment, the flange portion 31B, which corresponds to the flange portion 11B employed in the first embodiment, is mounted on the step portion 24 of the base member 22 and the bottom surface of the flange portion 31B is joined to the top surface of the step portion 24 (see FIG. 2A and FIG. 2B). That is, in the LED cap 30, the bottom surface of the flange portion 31B is an other member-joining portion 31C for joining to the base member 22 which is another member. As with the first embodiment, a base layer 12, an intermediate layer 13, and a surface layer 14 made of Au are formed in order from the main body 31 side on the bottom surface of the flange portion 31B of the LED cap 30, that is, the other member-joining portion 31C. The region where the base layer 12, the intermediate layer 13, and the surface layer 14 are formed is dotted in FIG. 3B.

The LED cap 30 can be manufactured in the same manner as the LED lens 10 described in the first embodiment, and is used in the same manner as the LED lens 10. Furthermore, the LED cap 30 can provide the same advantages as the LED lens 10 does.

### EXAMPLES

### (Inventive Example 1)

An LED lens 10 as shown in FIG. 1A and FIG. 1B was prepared as follows. First, silica powder was molded by a gel cast method and sintered, whereby a main body 11 made of silica glass and having a semispherical lens portion 11A that was 3 mm in lens diameter and 1.5 mm in lens height and a square flange portion 11B that was 3.5 mm × 3.5 mm in flange diameter and 0.5 mm in flange thickness was prepared. Then a 50-nm-thick Cr layer as a base layer 12, a 150-nm-thick Ni layer as an intermediate layer 13, and a 300-nm-thick Au layer as a surface layer 14 were formed in this order on the bottom surface of the flange portion 11B. The base layer 12, the intermediate layer 13, and the surface layer 14 were formed with a pressure condition appropriately selected from a range of 1 Pa to 3 Pa and an input power appropriately selected from a range of 120 W to 160 W by a sputtering machine. Subsequently, a photosensitive resist was applied to the base layer 12, the intermediate layer 13, and the surface layer 14 that were formed on the bottom surface of the flange portion 11B and then shaped into a frame-shaped pattern of 3.3 mm × 3.3 mm in outer diameters and 2.7 mm × 2.7 mm in inner diameters by a photolithographic method.

Porosities of the base layer 12, the intermediate layer 13, and the surface layer 14 of the prepared LED lens 10 were measured. In each measurement, an image of the surface of each layer was shot using the FE-SEM (S-4800) produced by Hitachi High-Technologies Corporation with an application voltage 5 kV and a magnification ×100,000. A porosity (%) was calculated by binarizing void portions of an image taken by the image processing module OpenCV using the programming language Python, dividing a total area of the void portions by an entire area, and multiplying a resulting quotient by 100. In doing so, portions where the contrast varied to a large extent were judged voids. The surface of the intermediate layer 13 was shot after it was made the outermost surface by etching away the surface layer 14 using a liquid chemical AURUM-314 (produced by Kanto Chemical Co., Inc.) at room temperature with an etching time 5 minutes. The surface of the base layer 12 was shot after it was made the outermost surface by etching away the surface layer 14 in the above manner and then etching away the intermediate layer 13 using, as a liquid chemical, a mixed acid Cu-02 (produced by Kanto Chemical Co., Inc.) at room temperature with an etching time 10 minutes.

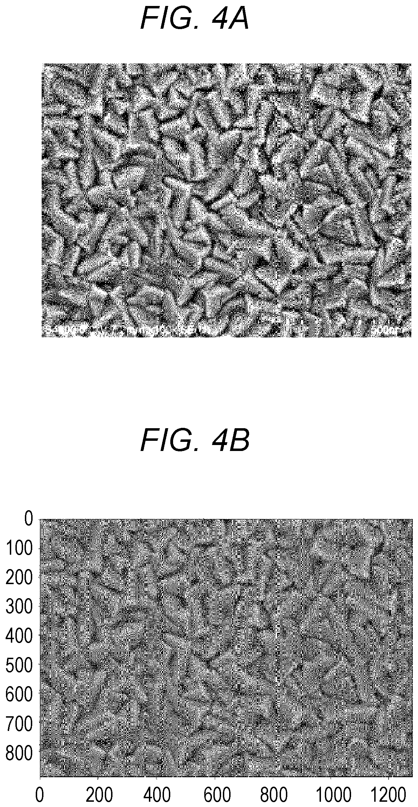

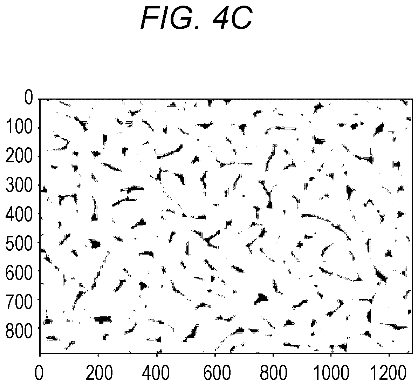

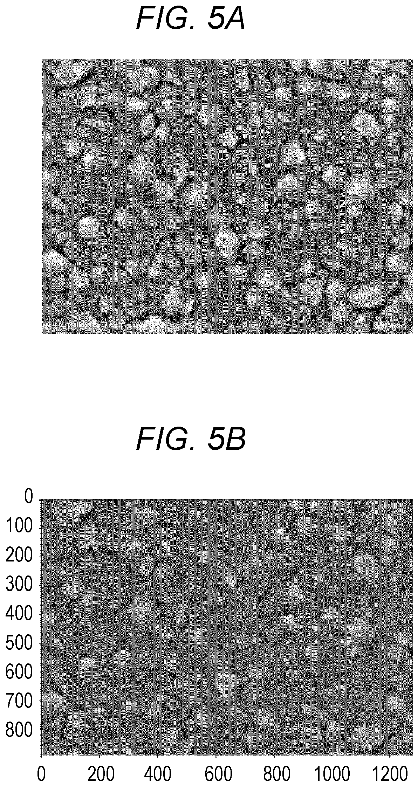

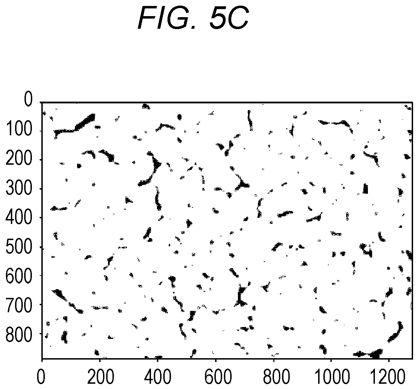

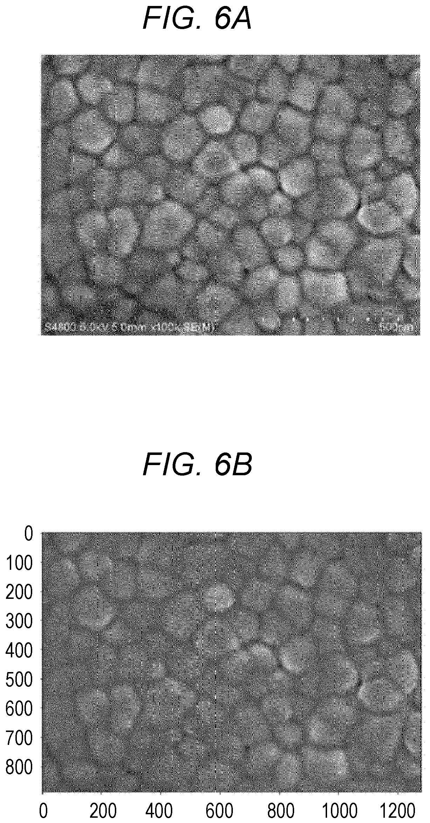

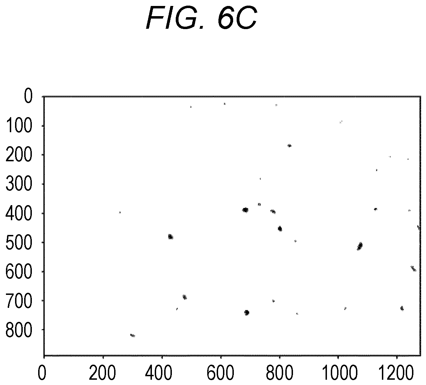

FIG. 4A shows a SEM image, FIG. 4B shows a processed image, and FIG. 4C shows an image of void portions, of the base layer 12. FIG. 5A shows a SEM image, FIG. 5B shows a processed image, and FIG. 5C shows an image of void portions, of the intermediate layer 13. FIG. 6A shows a SEM image, FIG. 6B shows a processed image, and FIG. 6C shows an image of void portions, of the surface layer 14. As shown in FIG. 4A to FIG. 4C, FIG.5A to FIG. 5C, and FIG. 6A to FIG. 6C, it was confirmed that each of the base layer 12, the intermediate layer 13, and the surface layer 14 had voids. The porosities of the base layer 12, the intermediate layer 13, and the surface layer 14 were 9.5%, 4.6%, and 0.2%, respectively.

Average particle diameters of the base layer 12, the intermediate layer 13, and the surface layer 14 were measured by a linear intercept method. The top surface of each layer was shot using the FE-SEM (S-4800) produced by Hitachi High-Technologies Corporation and an average particle diameter was calculated according to ISO 13383-1: 2012. Average particle diameters of the base layer 12, the intermediate layer 13, and the surface layer 14 as measured by the linear intercept method were 63 nm, 58 nm, and 62 nm, respectively.

Furthermore, Young's moduli of the base layer 12, the intermediate layer 13, and the surface layer 14 were measured. Surface acoustic waves produced by irradiating the top surface of each layer with pulse laser light (wavelength: 337 nm) were measured by a piezoelectric element and a Young's modulus was calculated from a dispersion curve by a surface acoustic wave method (according to the DIN (German Institute for Standardization) standard 50992-1). It was found that the Young's modulus of the base layer 12 was 50% of a Young's modulus of a bulk of the material Cr constituting the base layer 12, that the Young's modulus of the intermediate layer 13 was 60% of a Young's modulus of a bulk of the material Ni constituting the intermediate layer 13, and that the Young's modulus of the surface layer 14 was 40 GPa.

Next, a base member 22 made of aluminum nitride as shown in FIG. 2A and FIG. 2B was prepared as follows. A step portion 24 of the base member 22 was formed with a metallized layer 26 which had a first layer made of Au as a surface layer and an Ni layer between the first layer and the step portion 24. Then frame-shaped AuSn solder that was 3.2 mm × 3.2 mm in outer diameters, 2.8 mm × 2.8 mm in inner diameters, and 20 µm in thickness was inserted between the flange portion 11B of the main body 11 and the step portion 24 of the base member 22 and the LED lens 10 and the base member 22 were joined to each other under press conditions of a temperature 300°C, a pressure 0.5 MPa, and a pressing time 30 sec, whereby an LED device 20 was obtained. Ten LED devices 20 were prepared and none of the LED lenses 10 of the ten LED devices 20 were broken. Furthermore, a Fluorinert test (in general, gross leak test) was carried out to check the airtightness of the LED device 20, that is, the adhesion between the main body 11 and the base member 22. No leak was found in any of the ten LED devices 20 and hence it was confirmed that necessary airtightness was secured.

The Fluorinert test is based on the test method for airtightness specified in MIL-SPEC (MIL-STD-883). In this method, a fluorocarbons liquid called FLORINERT (trademark of 3M Company USA) having a high boiling point and low viscosity is stored in a container, and a sample is immersed in the FLORINERT heated to 125°C for 1 minute, and the airtightness is evaluated by observing whether or not bubbles leak from the sample.

### (Hereinafter referred to as the FLORINERT test.)

### (Comparative Example 1)

After a main body 11 was prepared in the same manner as in Inventive Example 1, a Cr layer as a base layer 12 having a porosity of 0.1%, an Ni layer as an intermediate layer 13 having a porosity of 0.1%, and an Au layer as a surface layer 14 having a porosity of 0.05% were formed in this order on the bottom surface of a flange portion 11B by a vacuum evaporation machine and shaped into a frame-like pattern in the same manner as in Inventive Example 1. The thickness of each layer was set the same as in Inventive Example 1 and a porosity of each layer was measured in the same manner as in Inventive Example 1. Subsequently, an LED device 20 was prepared by joining the prepared LED lens 10 to a base member 22 made of aluminum nitride in the same manner as in Inventive Example 1. Ten LED devices 20 were prepared. Cracks developing from the outer circumferential surface of the flange portion 11B were found in eight of the ten LED devices 20, that is, the LED lenses 10 of the eight LED devices 20 were broken.

### (Comparative Example 2)

After a main body 11 was prepared in the same manner as in Inventive Example 1, a Cr layer as a base layer 12, an Ni layer as an intermediate layer 13, and an Au layer as a surface layer 14 were formed in this order on the bottom surface of a flange portion 11B at the same thicknesses as in Inventive Example 1 by a sputtering machine and shaped into a frame-like pattern in the same manner as in Inventive Example 1. In the forming each layer, the porosities of the respective layers were increased by increasing the pressure of the sputtering machine and decreasing its output power. Porosities of the base layer 12, the intermediate layer 13, and the surface layer 14 that were measured in the same manner as in Inventive Example 1 were 25%, 25%, and 5%, respectively. Subsequently, an LED device 20 was prepared by joining the prepared LED lens 10 to a base member 22 made of aluminum nitride in the same manner as in Inventive Example 1. Ten LED devices 20 were prepared and none of the LED lenses 10 of the ten LED devices 20 were broken. Furthermore, a Fluorinert test was carried out to check the airtightness of the LED device 20, that is, the adhesion between the main body 11 and the base member 22. A leak was found in six of the ten LED devices 20. When the LED lens 10 and the base member 22 of each of the leak-found LED devices 20 were pulled away from each other with hands, the LED lens 10 was easily peeled off the base member 22. When each of the remaining four LED devices 20 was subjected to a use test, the LED lens 10 was peeled off the base member 22 during the use. That is, it was found that the connection state was wrong.

### (Comparison between Inventive Example 1 and Comparative Examples 1 and 2)

It was found from the results of Inventive Example 1 and Comparative Examples 1 and 2 that where the porosities of the base layer 12 and the intermediate layer 13 are low, stress cannot be lowered sufficiently and the LED lens 10 is broken. It was also found that where the porosities of the base layer 12 and the intermediate layer 13 are high, the LED lens 10 cannot be joined to the base member 22 satisfactorily with high airtightness.

### (Comparative Example 3)

A main body 11 was prepared and a base layer 12, an intermediate layer 13, and a surface layer 14 were formed on the bottom surface of a flange portion 11B and shaped into a frame-like pattern in the same manner as in Inventive Example 1. In doing so, the thicknesses of the base layer 12, the intermediate layer 13, and the surface layer 14 were set at 300 nm, 500 nm, and 800 nm, respectively. The porosity of each layer was the same as in Inventive Example 1. Subsequently, an LED device 20 was prepared by joining the prepared LED lens 10 to a base member 22 made of aluminum nitride in the same manner as in Inventive Example 1. Ten LED devices 20 were prepared. Cracks developing from the outer circumferential surface of the flange portion 11B were found in seven of the ten LED devices 20, that is, the LED lenses 10 of the seven LED devices 20 were broken.

### (Comparative Example 4)

A main body 11 was prepared and a base layer 12, an intermediate layer 13, and a surface layer 14 were formed on the bottom surface of a flange portion 11B and shaped into a frame-like pattern in the same manner as in Inventive Example 1. In doing so, the thicknesses of the base layer 12, the intermediate layer 13, and the surface layer 14 were set at 10 nm, 50 nm, and 100 nm, respectively. The porosity of each layer was the same as in Inventive Example 1. Subsequently, an LED device 20 was prepared by joining the prepared LED lens 10 to a base member 22 made of aluminum nitride in the same manner as in Inventive Example 1. Ten LED devices 20 were prepared and none of the LED lenses 10 of the ten LED devices 20 were broken. Furthermore, the FLORINERT test was carried out to check the airtightness of the LED device 20, that is, the adhesion between the main body 11 and the base member 22. A leak was found in all of the ten LED devices 20. When the LED lens 10 and the base member 22 of each of the leak-found LED devices 20 were pulled away from each other with hands, the LED lens 10 was easily peeled off the base member 22. It was therefore found that the connection state was wrong.

### (Comparison between Inventive Example 1 and Comparative Examples 3 and 4)

It was found from the results of Inventive Example 1 and Comparative Examples 3 and 4 that where the base layer 12, the intermediate layer 13, and the surface layer 14 are thick, stress cannot be lowered sufficiently and the LED lens 10 is broken. It was also found that where the base layer 12, the intermediate layer 13, and the surface layer 14 are thin, the LED lens 10 cannot be joined to the base member 22 satisfactorily with high airtightness.

Although the present invention has been described above by way of the embodiments, the invention is not limited to the above embodiments and various modifications are possible. For example, although in the embodiments the LED lens 10 and the LED cap 30 each of which is a member for a light source were described as silica members, the invention can also be applied to members made of other materials for light sources. Furthermore, the invention can also be applied to silica members other than members for light sources, such as an optical window for an optical apparatus and a lid for a crystal oscillator.

Furthermore, although the specific configurations of the LED lens 10 and the LED cap 30 were described in the above embodiments, they may have other configurations. For example, although the above embodiments and Examples are directed to the case that the outer circumference shape of the flange portion 11B or 31B is a square, the flange portion may be shaped like a circle or a polygon other than a square. Furthermore, the flange portion 11B or 31B may be omitted, in which case, for example, a circumferential portion of the flat portion of the lens portion 11A or an opening end portion of the cap portion 31A may be an other member-joining portion 11C or 31C. Still further, the above embodiment and Examples are directed to the case that the lens portion 11A is shaped like a semisphere, its shape may be other than a semisphere (spherical surface), such as an aspherical shape or a half of a prolate spheroid.

In addition, although the specific configurations of the base member 22 were described in the above embodiment and Examples, it may have other configurations. For example, although the embodiment and Examples are directed to the case that one surface of a flat plate is formed with the recess 23 in which the LED 21 is provided, the LED 21 may be mounted on a flat plate that is not formed with the recess 23 or provided in a body capable of enclosing it.

Although the preferred embodiments of the present invention have been described above, the invention is not limited to the above-described embodiments. Various design changes are possible within the scope of the claims.

The present application is based on Japanese Patent Application No. 2020-217879 filed on December 25, 2020 and Japanese Patent Application No. 2021-172818 filed on October 22, 2021, the disclosures of which are incorporated herein by reference.

### INDUSTRIAL APPLICABILITY

In particular, the present invention can be applied to members for light sources or the like.

### REFERENCE SIGNS LIST

- 10: LED lens
- 11: Main body
- 11A: Lens portion
- 11B: Flange portion
- 11C: Other member-joining portion
- 12: Base layer
- 13: Intermediate layer
- 14: Surface layer
- 20: LED device
- 21: LED
- 22: Base member
- 23: Recess
- 24: Step portion
- 25: Solder layer
- 26: Metallized layer
- 30: LED cap
- 31: Main body
- 31A: Cap portion
- 31B: Flange portion
- 31C: Other member-joining portion

## Claims

1. A silica member comprising a main body comprising silica glass,
wherein the main body has an other member-joining portion for joining to another member,
wherein the other member-joining portion has a base layer, an intermediate layer, and a surface layer comprising Au that are formed on the other member-joining portion in this order from the main body, and
wherein the base layer has a porosity of higher than or equal to 5% and lower than or equal to 10%, the intermediate layer has a porosity of higher than or equal to 4% and lower than or equal to 5%, the base layer has a thickness of larger than or equal to 20 nm and smaller than or equal to 100 nm, and the intermediate layer has a thickness of larger than or equal to 100 nm and smaller than or equal to 200 nm.

2. The silica member according to claim 1, wherein the porosity of the base layer is higher than the porosity of the intermediate layer.

3. The silica member according to claim 1 or 2, wherein the surface layer has a porosity of higher than or equal to 0.1% and lower than or equal to 0.5% and a thickness of larger than or equal to 150 nm and smaller than or equal to 500 nm.

4. The silica member according to any one of claims 1 to 3, wherein the base layer comprises at least one of a Cr layer and a Ti layer and the intermediate layer comprises at least one of an Ni layer and a Ti layer.

5. The silica member according to any one of claims 1 to 4, wherein the base layer has an average particle diameter as measured according to a linear intercept method of larger than or equal to 40 nm and smaller than or equal to 80 nm, the intermediate layer has an average particle diameter as measured according to the linear intercept method of larger than or equal to 50 nm and smaller than or equal to 70 nm, and the surface layer has an average particle diameter as measured according to the linear intercept method of larger than or equal to 50 nm and smaller than or equal to 70 nm.

6. The silica member according to any one of claims 1 to 5, wherein the silica member is an LED lens or an LED cap.

7. An LED device comprising:
an LED;
a base member which supports the LED; and
the silica member according to any one of claims 1 to 6 that is joined to the base member so as to cover the LED,
wherein the base member has a silica member-joining portion for joining to the silica member,
wherein a metallized layer comprising a first layer comprising Au on its surface is formed on the silica member-joining portion, and
wherein the other member-joining portion of the silica member is joined to the silica member-joining portion of the base member by a solder layer comprising an AuSn solder.
